(19) Europäisches Patentamt
European Patent Office
Office européen des brevets

(11) Veröffentlichungsnummer: **0 028 583**
**B1**

(12) # EUROPÄISCHE PATENTSCHRIFT

(45) Veröffentlichungstag der Patentschrift: **06.06.84**

(51) Int. Cl.³: **C 08 G 59/72**, C 08 G 59/42, H 01 B 3/40

(21) Anmeldenummer: **80810326.1**

(22) Anmeldetag: **30.10.80**

(54) **Verfahren zur Herstellung von Epoxidharzgiesskörpern.**

(30) Priorität: **05.11.79 CH 9907/79**

(43) Veröffentlichungstag der Anmeldung: **13.05.81 Patentblatt 81/19**

(45) Bekanntmachung des Hinweises auf die Patenterteilung: **06.06.84 Patentblatt 84/23**

(84) Benannte Vertragsstaaten: **CH DE FR GB LI NL**

(56) Entgegenhaltungen:
**DE - A - 1 495 390**
**DE - A - 1 770 024**
**DE - A - 2 132 683**
**GB - A - 872 306**
**US - A - 2 824 083**

(73) Patentinhaber: **CIBA-GEIGY AG, Postfach, CH-4002 Basel (CH)**

(72) Erfinder: **Zuppinger, Paul, Dr., Bodenweg 14, CH-4144 Arlesheim (CH)**
Erfinder: **Baumann, Dieter, Habsburgerstrasse 74, CH-4310 Rheinfelden (CH)**

**EP 0 028 583 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Für die Herstellung von Kunststoffgießkörpern, welche beispielsweise bei der Ummantelung wärmeempfindlicher elektronischer Bauteile in der Massenproduktion eine große Rolle spielen, wird bis heute vorwiegend die Polyurethantechnik angewandt. Der Grund hierfür liegt darin, daß bei Polyurethansystemen nur kurze Formbelegungszeiten von beispielsweise unter 5 Minuten erforderlich sind und daß das pot-life bei Raumtemperatur genügend lang ist. Letzteres bedeutet, daß bei Nichtanwendung von komplizierten, maschinellen Dosiervorrichtungen für die Herstellung auch kleinerer Artikel verhältnismäßig große Ansätze zum Einsatz kommen können. Das pot-life beträgt mindestens 30 Minuten bis zu mehreren Stunden. Die Anwendung einer derartigen Polyurethantechnik weist allerdings auch Nachteile auf. Sie zeichnet sich bekanntlich durch eine äußerst große Wasserempfindlichkeit aus, die zusätzliche Entwässerungsaktionen und vielfache Vorkehrungen erforderlich machen. Die schließlich erhältlichen Polyurethangießkörper sind im Vergleich zu Epoxidharzsystemen ungünstig in bezug auf Alterung, Wasseraufnahme und elektrische Eigenschaften.

Es sind auch bereits Epoxidharz-Gießsysteme bekannt, bei welchen geringe Formbelegungszeiten (z. B. 5 Min. bei 100° C) erforderlich sind und welche ein pot-life (bei etwa 100 g) von mehr als 30 Minuten bei Raumtemperatur aufweisen. Diesbezüglich ist auf die amin-härtbaren Bisphenol-A-Epoxidharze hinzuweisen. Derartige Epoxidharz-Gießsysteme weisen aber die nachteilige Besonderheit starker Exothermie auf. Sie sind deshalb in sehr vielen Fällen für die Ummantelungsgießverfahren bei Bauteilen der Elektronik gänzlich ungeeignet. Bekanntlich enthalten Elektronikbauteile häufig Lötstellen, Metallbeschichtungen und -impfungen und dergleichen, welche höheren Temperaturen nicht ausgesetzt werden können, ohne Schaden zu erleiden. In vielen Fällen führt die Exothermie auch zu Lunkerbildungen, welche unerwünscht sind.

In der US-Patentschrift 3 941 725 sind bereits verschäumbare Epoxidharz-Mischungen beschrieben, welche neben der Polyepoxidverbindung und dem Treibmittel Bortrifluorid sowie eine Anzahl von verschiedenen Komplexen mit Bortrifluorid, Carbonsäureanhydride, Wasser, Polyole und cyclische Äther enthalten können. Derartige Systeme sind stark beschleunigt, so daß nach der Herstellung der Mischung sehr schnell die Verschäumung eintritt und das pot-life sehr kurz ausfällt. Enthalten derartige Mischungen kein Treibmittel, so verlangsamt sich die Reaktionsgeschwindigkeit derselben praktisch nicht. Eher tritt infolge des Fortfalls der Aufwendung der Treibenergie eine weitere Beschleunigung und Exothermie ein. Für die einfache, normale Herstellung von Gießkörpern sind solche Systeme allein schon wegen des zu kurzen pot-life nicht geeignet. Allenfalls ist die Gießtechnik dann anwendbar, wenn komplizierte und aufwendige maschinelle Dosiervorrichtungen zum Einsatz kommen.

Die Aufgabe der Erfindung liegt darin, ein Verfahren zur Herstellung von Epoxidharzen zu finden, welches sich insbesondere für die Herstellung von Gießkörpern verwenden läßt und welches die Nachteile der als Stand der Technik angeführten Epoxidharz-Systeme nicht aufweist. Die Formbelegungszeit soll also bei 100° C 5 Minuten nicht überschreiten und das pot-life bei Raumtemperatur (100 g) soll vorzugsweise mindestens 30 Minuten betragen, so daß sich eine aufwendige maschinelle Dosiervorrichtung erübrigt. Gleichzeitig soll bei einem solchen Herstellungsverfahren aber nicht wie bei dem bekannten Verfahren, welches auf der Aminhärtung von Bisphenol-A-Epoxidharzen beruht, starke Exothermie auftreten. Im Gegensatz zu dem bekannten Verfahren, soll es geradezu prädestiniert für das Ummantelungsgießen von wärmeempfindlichen elektrischen Teilen sein. Die Endprodukte, die sich bei Anwendung eines solchen Verfahrens ergeben, sollen im übrigen mindestens so gute mechanische, chemische und elektrische Eigenschaften aufweisen, wie die Werkstoffe, welche sich durch Gießverfahren anderer bekannter, schnellhärtender Systeme mit genügend langem pot-life herstellen lassen.

Gegenstand der Erfindung ist ein Verfahren zur Herstellung von Epoxidharzgießkörpern durch Umsetzung einer flüssigen, polyfunktionellen Epoxidverbindung, eines Carbonsäureanhydrids, gegebenenfalls einer Carbonsäure und/oder eines Carbonsäureesters, einer Bortrifluorid-Komplexverbindung, Wasser, eines cyclischen Äthers und einer oder mehrerer Verbindungen (X), welche mindestens 2 OH-Gruppen oder mindestens 2 COOH-Gruppen oder gleichzeitig mindestens 1 OH-Gruppe und mindestens 1 COOH-Gruppe aufweisen, aus der Gruppe aliphatischer Glykole, Polyester und Polyäther mit endständigen OH-Gruppen, Polyester mit endständigen COOH-Gruppen und Halbester von Dicarbonsäureanhydriden, welche die Anhydridgruppe an einem carbocyclischen Ring tragen, mit Polyolen, dadurch gekennzeichnet, daß man als Bortrifluorid-Komplexverbindung eine Zinkfluorborat-Komplexverbindung und als cyclischen Äther Tetrahydropyran einsetzt, wobei die Mischungsbestandteile bei der Umsetzung in einem solchen Mengenverhältnis vorliegen, daß auf 100 Gewichtsteile der Epoxidverbindung mehr als 10 Gewichtsteile, vorzugsweise 50 Gewichtsteile der Summe aus Carbonsäureanhydrid, gegebenenfalls Carbonsäure und/oder Carbonsäureester, Zinkfluorborat-Komplexverbindung, Wasser, Tetrahydropyran und Verbindung (X) kommen und auf 1 Epoxidäquivalent 0,01 bis 1,0 Mol Wasser, 0,02 bis 0,2 Mol Tetrahydropyran, 0,5 bis 1,8 Säureäquivalente und 0,5 bis 2,5 g $BF_3$ der Zinkfluorborat-Komplexverbindung kommen, mit der Maßgabe, daß bei der Berechnung der Carbonsäureäquivalente Carbonsäureanhydrid und Carbonsäureester als Carbonsäure gerechnet werden.

Bevorzugt wird erfindungsgemäß als Zinkfluorborat-Komplexverbindung eine solche der Formel

$Zn(BF_4)_2 \cdot 4\ H_2O$

oder aber eine solche einsetzt, welche Tetrahydropyran und gegebenenfalls Wasser enthält, wobei jeweils das komplex gebundene Wasser zu dem gesamten Wasser des Reaktionsgemisches und das komplex gebundene Tetrahydropyran zu dem gesamten Tetrahydropyran des Reaktionsgemisches zu zählen sind.

Gemäß der Erfindung werden bevorzugt ein bei Raumtemperatur flüssiges Carbonsäureanhydrid oder ein bei Raumtemperatur flüssiges Carbonsäureanhydridgemisch oder aber ein bei Raumtemperatur flüssiges Gemisch eines oder mehrerer Carbonsäureanhydride mit einer oder mehreren Carbonsäuren und/oder einem oder mehreren Carbonsäureestern eingesetzt.

Geeignete flüssige Anhydride sind z. B. Hexahydrophthalsäureanhydrid, Methyltetrahydrophthalsäureanhydrid und entsprechende Isomerengemische oder Methyl-1,4-endomethylen-tetrahydrophthalsäureanhydrid. Bevorzugt sind auch Gemische von 2 oder mehreren Anhydriden, welche aufgrund der Kristallisationseigenschaften (z. B. Eutektikumbildung) bei Raumtemperatur flüssig sind. Hier sind also durchaus auch Kombinationen mit festen Anhydriden, wie beispielsweise Phthalsäureanhydrid und Tetrahydrophthalsäureanhydrid möglich. Die Erfindung schließt auch nicht grundsätzlich die Verwendung von bei Raumtemperatur festen Anhydridgemischen aus. Hier sind allerdings nur solche Anhydridgemische einsetzbar, welche mit allen übrigen Bestandteilen des erfindungsgemäßen Gemisches sehr leicht eine Lösung bilden.

Erfindungsgemäß kommen die folgenden Verbindungen (X) bevorzugt zum Einsatz:

1. Alkylenglykole mit mindestens 2 OH-Gruppen und mit 2 bis 10 Kohlenstoffatomen oder Polyalkylenglykoläther mit einem Molekulargewicht von maximal 1000, vorzugsweise etwa 500, wobei in der Reaktionsmischung auf 1 Epoxidäquivalent 0,01 bis 0,08, vorzugsweise 0,02 bis 0,05 OH-Äquivalente dieser Verbindung (X) kommen. Derartige Alkylenglykole sind beispielsweise Äthylenglykol, Propylenglykol, 1,4-Butandiol und die weiteren Homologen mit bis zu 10 C-Atomen. Grundsätzlich können die Glykole auch verzweigt sein. Bevorzugt werden Polyalkylenglykoläther mit Molekulargewichten bis zu etwa 500. Das Molekulargewicht von 1000 sollte nicht überschritten werden. Beispiele für solche Polyalkylenglykoläther sind Polypropylenglykoläther und Polyäthylenglykoläther. Auch hier sind verzweigte Verbindungen gut geeignet.
2. Polyester mit mindestens 2 OH-Gruppen, welche entweder durch Reaktion einer organischen Dicarbonsäure oder eines veresterungsfähigen Derivates dieser Dicarbonsäure mit einem Diol oder einem veresterungsfähigen Derivat dieses Diols im Überschuß, oder durch Reaktion der COOH-Gruppe eines Polylactons mit einem Polyol (oder Polyolderivat) gewonnen werden, wobei in der Reaktionsmischung auf 1 Epoxidäquivalent 0,01 bis 0,08, vorzugsweise 0,02 bis 0,05, OH-Äquivalente dieser Verbindung (X) kommen. Derartige Polyester sind beispielsweise solche auf der Basis von Adipinsäure und Diäthylenglykol oder 1,4-Butandiol, welche z. B. unter der Handelsbezeichnung Desmophen® (Bayer) laufen. Handelsübliche Polyester auf der Basis von Polycarpolacton sind beispielsweise Capa® (Solvay) und Niax® (Union Carbide). In manchen Fällen genügt es auch, dem Reaktionsgemisch ein monomeres Lacton zuzugeben, weil sich sekundär daraus ein obigem Polyester äquivalentes Produkt bildet.
3. Polyester mit mindestens 2 COOH-Gruppen, welche entweder durch Reaktion einer organischen Dicarbonsäure oder eines veresterungsfähigen Derivates dieser Carbonsäure im Überschuß mit einem Diol oder einem veresterungsfähigen Derivat dieses Diols, oder durch Reaktion der OH-Gruppe eines Polylactons mit einer organischen Dicarbonsäure (oder Derivat davon) gewonnen werden, wobei in der Reaktionsmischung auf 1 Epoxidäquivalent 0,01 bis 0,08, vorzugsweise 0,02 bis 0,05, COOH-Äquivalente dieser Verbindung (X) kommen. Zu diesen speziellen bevorzugten Polyestern zählen auch carbocyclische oder heterocyclische Ringe enthaltende saure Polyester der Formel

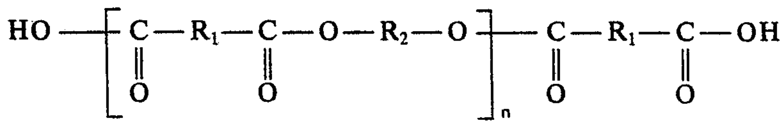

(I)

wobei in der Formel (I) die Symbole $R_1$ und $R_2$ zweiwertige aliphatische araliphatische, cycloaliphatische, cycloaliphatisch-aliphatische, aromatische oder heterocyclische Reste bedeuten, wobei mindestens einer der beiden Reste $R_1$ und $R_2$ im wiederkehrenden Strukturelement einen carbocyclischen oder heterocyclischen Ring oder ein carbocyclisches oder heterocyclisches Ringsystem enthalten muß, und wobei n eine ganze Zahl im Wert von 2 bis 10, vorzugsweise von 2 bis 5, bedeutet, und wobei ferner im wiederkehrenden Strukturelement der Formel

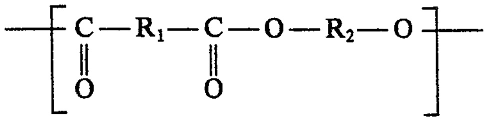

(I a)

der Quotient $\frac{Z_g}{Z_r}$ den Wert 2 bis 13, vorzugsweise 4 bis 10, besitzt, worin $Z_g$ die totale Anzahl der Glieder in der geraden Kette des Strukturelementes, und $Z_r$ die Anzahl der aus einem Ring oder Ringsystem bestehenden Glieder des Strukturelementes bedeuten, wobei die erstgenannten Glieder

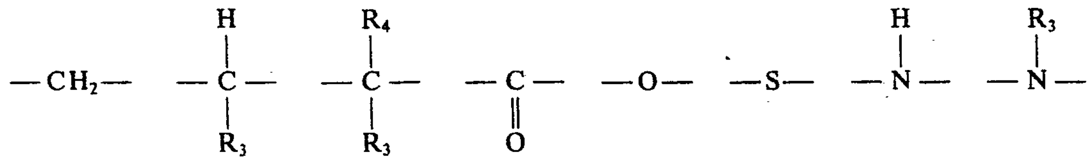

(worin $R_3$ und $R_4$ je eine Alkylgruppe oder Alkenylgruppe bedeuten) oder alicyclische, heterocyclische und aromatische Ringe bzw. kondensierte oder anellierte Ringsysteme sind, wobei jedoch Ringsysteme, in welchen zwei Ringe durch ein gemeinsames Spirokohlenstoffatom verknüpft sind, als zwei Ringglieder gezählt werden.
Diese speziellen sauren Polyester sind ausführlicher in der US-Patentschrift 3 624 180 beschrieben.

4. Polyäther mit mindestens 2 OH-Gruppen, welche durch Vorverlängerungsreaktion von niedermolekularen Polyolen mit Äthylen- oder Propylenoxid hergestellt werden, wobei in der erfindungsgemäß angewandten Reaktionsmischung auf 1 Epoxidäquivalent 0,01 bis 0,08 vorzugsweise 0,02 bis 0,05 OH-Äquivalente dieser Verbindung (X) kommen.
Beispiele für derartige Polyäther sind Handelsprodukte, welche unter folgenden Bezeichnungen laufen: Baygal® (Bayer), Caradol® (Shell), Lupranol® (BASF), Niax® (Union Carbide), Pluracol® (Ugine Kühlmann) und Voranol® (Dow-Chemical). Äquivalente zu diesen Polyäthern sind solche, welche sich durch die Polymerisation von Tetrahydrofuran ergeben, wie z. B. Polymeg® (The Quaker Oats Co., USA).
5. Halbester aus Phthalsäureanhydrid, Tetrahydrophthalsäureanhydrid oder Hexahydrophthalsäureanhydrid mit einem aliphatischen Polyol, welche auch infolge von Weiterveresterung als Oligomeres mit einem Molekulargewicht bis zu 500 vorliegen können.

Diese Halbester (insbesondere auch Mischungen derselben) liegen in analogen Konzentrationen in der Reaktionsmischung des erfindungsgemäßen Verfahrens vor wie die anderen bevorzugten, zuvor erwähnten Verbindungen (X). Die bevorzugten Halbester sind besonders deshalb so wertvoll, weil sie überraschend eine ausgesprochene Kristallisationsinhibierung verursachen und somit das Reaktionsgemisch für das erfindungsgemäße Verfahren in flüssigem Zustand erhalten.

Geeignete flüssige Epoxidharze für das erfindungsgemäße Verfahren sind insbesondere Harze auf der Basis von Bisphenol-A, Bisphenol-F, Epoxycresol- und Epoxyphenol-Novolaken, ferner epoxidgruppenhaltige Polyester, aliphatische Polyglycidyläther und cycloaliphatische Epoxidharze. Auch der Einsatz von Halogen, insbesondere Brom, enthaltenden Epoxidverbindungen, wie z. B. von di-bromierten Bisphenol-A-glycidyläthern und Dibromkresolglycidyläthern, ist in die Erfindung mit eingeschlossen. Derartige Zusätze können bewirken, daß die erhältlichen Gießkörper flammfest sind. Gut geeignet sind auch Gemische verschiedener Epoxidharze.

Die Reaktionsgemische für das erfindungsgemäße Verfahren können auch übliche Zusatzstoffe, wie Füllstoffe (z. B. Quarz-, Schiefer-, MgCa-Silikat-, Baryt- und Aluminiumoxidmehl), Farbstoffe, Entformungsmittel (z. B. Silicone), Flammschutzmittel und dergleichen enthalten.

Die erfindungsgemäße Umsetzung kann in unterschiedlicher Weise erfolgen. Eine Methode besteht darin, daß alle Bestandteile auf einmal in das Gefäß, aus dem gegossen bzw. für den Gießvorgang entnommen wird, zugegeben und gemischt werden. Es können aber auch die verschiedensten Vormischungen hergestellt werden. In solchen Fällen ist allerdings darauf zu achten, daß in diesen Vormischungen nicht neben den Epoxidverbindungen bereits solche Substanzen enthalten sind, welche eine Härtung (Vernetzung oder Polymerisation) der Epoxidharze verursachen. Bevorzugt wird bei der Herstellung der Reaktionsgemische für das erfindungsgemäße Verfahren von 2 Vormischungen bzw. Komponenten ausgegangen, nämlich von einer Harzkomponente (A) und einer Härterkomponente (B). Die Harzkomponente (A) besteht aus dem Epoxidharz und gegebenenfalls gegenüber der Epoxidgruppe indifferenten Zusatzstoffen, wie insbesondere Füllstoffe, Farbstoffe und Entformungsmittel. Die Härterkomponente (B) enthält dagegen folgende Substanzen: das Carbonsäureanhydrid, gegebenenfalls die Carbonsäure und/oder Carbonsäureester, die Zinkfluorborat-Komplexverbindung, welche Wasser und gegebenenfalls Tetrahydropyran enthält, eine oder mehrere der Verbindungen (X) und gegebenenfalls noch zusätzliches Wasser und zusätzliches Tetrahydropyran. Grundsätzlich kann die Härterkomponente (B) aber auch (ganz oder teilweise) die gegenüber Epoxidgruppen indifferenten Substanzen enthalten, welche meistens zweckmäßigerweise in der Harzkomponente (A) enthalten sind, allerdings mit dem Vorbehalt, daß diese Substanzen dann möglichst auch gegenüber den Härtern und Beschleunigern indifferent sind. Umgekehrt kann die Harzkomponente (A) beispielsweise auch (ganz oder teilweise) das Tetrahydropyran enthalten.

Das erfindungsgemäße Verfahren kann gegebenenfalls auch stufenweise durchgeführt werden. So stört z. B. nicht, wenn in begrenztem Maße zur Durchführung der eigentlichen Hauptumsetzung geringe Mengen von Wasser oder OH-Gruppen aufweisenden Verbindungen mit dem Carbonsäureanhydrid reagieren. Dabei werden entsprechend kleine Mengen von Carbonsäuren oder Carbonsäureestern entstehen.

Das erfindungsgemäße Verfahren betrifft insbesondere das einfache Gießverfahren unter Benutzung von Gießformen, schließt aber durchaus auch das Druckgelierverfahren und das Spritzgießen mit ein.

Die erfindungsgemäße Umsetzung wird vorzugsweise bei Temperaturen zwischen 75 und 120°C durchgeführt. Beim einfachen Gießverfahren wird im allgemeinen so gearbeitet, daß die Formen auf etwa 80°C aufgeheizt werden, in die dann die zweckmäßiger Weise Raumtemperatur aufweisende Reaktionsmischung für das erfindungsgemäße Verfahren gegeben wird. In vielen Fällen genügt es, den erstarrten Gießkörper sobald als möglich der Form zu entnehmen. Er weist dann bereits die angestrebten wertvollen Eigenschaften auf. In manchen Fällen ist es nötig, eine Nachtemperierung bei Temperaturen bis zu 100°C vorzugsweise bei 80°C, anzuschließen.

Die nach dem erfindungsgemäßen Verfahren hergestellten Gießkörper können elektrische Teile, insbesondere wärmeempfindliche Elektronik-Elemente, umhüllen bzw. einkapseln.

Die Erfindung wird in den nachfolgenden Beispielen näher erläutert. Werden hier Teile angegeben, so sind (wenn nicht ausdrücklich anders angegeben) stets Gewichtsteile gemeint.

## Beispiel 1

Bei dem Versuch werden die folgenden Harzkomponente (A) und Härterkomponente (B) verwendet:

### Harzkomponente ($A^1$)

Sie besteht aus einer Mischung von 34,5 Teilen Bisphenol-A-glycidyläther (5,2 Mol Epoxid/kg Harz) und 50,0 Teilen Mg-Ca-Silicat.

### Härterkomponente ($B^1$)

Sie besteht aus einer Mischung folgender Substanzen:

a) 8,6 Teile Anhydridgemisch aus
 10 Teilen Phthalsäureanhydrid,
 15 Teilen Tetrahydrophthalsäureanhydrid
 75 Teilen Hexahydrophthalsäureanhydrid
b) 5,2 Teile Polyesterpolyol (Typ Capa 305®, der Firma Solvay);
 5,5 Mol OH-/kg bzw. OH-Äquivalentgewicht ~ 180.
c) 1,7 Teile einer Zinkfluorborat-Komplexverbindung, die wie folgt erhalten wird:

In einem 1-l-Rundkolben, der mit Rückflußkühler und Rührer versehen ist, werden 378,6 Teile Tetrahydropyran und 123 Teile Zinkfluorid vorgelegt. Unter Rühren werden innerhalb von 10 Minuten 207,6 Teile Borfluorid-Dihydrat portionenweise zugegeben. Das Gemisch erwärmt sich dabei auf 70°C. Danach wird es bei 80°C während 30 Minuten unter Rückfluß weitergerührt. Nach Abkühlung auf Raumtemperatur wird das Reaktionsgemisch über eine Drucknutsche filtriert.

Die Harzkomponente ($A^1$) wird während 1 Minute mit der Härterkomponente ($B^1$) in einem solchen Mengenverhältnis gemischt, daß auf 100 Teile Epoxidharz 45 Teile Härterkomponente ($B^1$) kommen. Auf 1 Epoxidäquivalent entfallen somit 0,38 Mol Anhydrid, 0,03 OH-Polyoläquivalente und 0,054 Mol Wasser. Im Vacuum ($1{,}333 \cdot 10^2$ Pa) wird das Gemisch während 10 Minuten entlüftet. Das entstandene Reaktionsgemisch ist bei Raumtemperatur gut gießbar, weist ein pot-life von ca. 50 Minuten auf und geliert bei 80°C innerhalb von 40 Sekunden. Die Reaktionsmischung wird in Aluminiumformen gegossen, welche die Abmessungen $3 \cdot 20 \cdot 25$ cm (= 3,2 kg) und eine Temperatur von 80°C aufweisen. Nach einer Formbelegungszeit von 3 Minuten, in der die Temperatur nicht wesentlich über 80°C steigt, wird der Gießkörper sofort entnommen. Ein Teil der Prüfkörper wird während 10 Stunden bei 80°C nachgehärtet.

Die Eigenschaften der Gießkörper sind in Tabelle 1 zusammengestellt.

## Beispiel 2

Es wird analog Beispiel 1 verfahren, nur mit dem Unterschied, daß die Harzkomponente ($A^2$) hier

37,0 Teile anstelle von 34,5 Teilen des Bisphenol-A-glycidyläthers enthält und daß in der Härterkomponente ($B^2$) 9,6 Teile des Anhydridgemisches, 1,9 Teile des Polyesterpolyols (Capa 305®) und 1,9 Teile der Zinkfluorborat-Komplexverbindung enthalten sind.

Es resultiert ein Gießharz, das bei 80°C innerhalb von 30 Sekunden geliert und welches ein pot-life bei Raumtemperatur (100 g) von 45 Minuten aufweist. Die Reaktionsmischung wird gemäß den Angaben in Beispiel 1 vergossen, wobei analog Beispiel 1 praktisch keine Exothermie auftritt. Der nachträglich noch während 10 Stunden bei 80°C nachgehärtete Gießkörper weist praktisch die gleichen Eigenschaften wie der nach Beispiel 1 erhaltene und nachgehärtete Gießkörper auf. Ausnahmen bilden hier der Schubmodul $T_G$max, der E-Modul sowie die elektrischen Werte, wie aus der Tabelle 1 zu ersehen ist.

## Beispiel 3

Als Harzkomponente ($A^3$) wird lediglich das Epoxidharz nach Beispiel 1 verwendet. Die Härterkomponente ($B^3$) setzt sich wie folgt zusammen.

a) 25 Teile Methyltetrahydrophthalsäureanhydrid,
b) 5 Teile ε-Caprolacton,
c) 5 Teile Zinkfluorborat-Komplexverbindung gemäß Beispiel 1,
d) 3,3 Teile Tetrahydropyran.

100 Teile des Epoxidharzes werden mit 38,3 Teilen der Härterkomponente ($B^3$) vermischt. Es resultiert ein Gießharz, das bei 80°C innerhalb von 50 Sekunden geliert und ein pot-life bei Raumtemperatur (100 g) von 45 Minuten aufweist.

Es wird wie in Beispiel 1 in die Form gegossen und während 6 Stunden ohne Nachheizung stehen gelassen. Bei diesem Vergießen steigt die Temperatur ebenfalls nicht wesentlich über 80°C. Nachträglich wird der aus der Form entnommene Gießkörper während 3 Stunden bei 100°C nachgehärtet. Die Prüfwerte sind ebenfalls in Tabelle 1 angeführt.

Tabelle 1

| | Prüfnorm | Beispiel Nr. 1 direkt nach Entformung | nach 10 h 80°C Nachhärtung | 2 nach 10 h 80°C Nachhärtung | 3 6 h bei R.T.*) + 3 h 100°C Nachhärtung |
|---|---|---|---|---|---|
| GUT (°C)**) (DTA-Mettler 1000) | | 58 | 86 | praktisch wie in Beispiel 1 | 94 |
| Schubmodul; $T_G$ max. °C | DIN 53 445 | 90 | 102 | 112 | 114 |
| Shore-Härte D | | 92 | 93 | praktisch wie in Beispiel 1 | 87 |
| Schlagbiegefestigkeit KJ/m² | DIN 53 453 | 10 | 10 | desgl. | 19 |
| E-Modul N/mm² | DIN 53 457 | 6130 | 6520 | 6770 | 2910 |
| Biegefestigkeit N/mm² | DIN 53 452 | 78 | 83 | praktisch wie in Beispiel 1 | 135 |
| Kochwasseraufnahme (4 h 98°C) % | | 1,2 | 0,9 | desgl. | 1,57 |
| Dielektr. Verlustfaktor tg $\delta \cdot 10^2$ | | | | | |

Tabelle 1 (Fortsetzung)

| | Prüfnorm | Beispiel Nr. 1 direkt nach Entformung | nach 10 h 80° C Nachhärtung | 2 nach 10 h 80° C Nachhärtung | 3 6 h bei R.T.*) + 3 h 100° C Nachhärtung |
|---|---|---|---|---|---|
| R.T.*) | | R.T.*) | DIN 53 483 | 0,49 | 0,28 |
| desgl. | 0,44 | | | | |
| 80° C | | 30;96 | 3,6 | desgl. | 4,56 |
| nach 4 h Kochwasserlagerung | | | | | |
| R.T.*) | | 4,25 | 2,2 | desgl. | 1,43 |
| 80° C | | 38,12 | 9,23 | desgl. | 24,27 |
| Relative Dielektrizitätskonst. $E_r$ | | | | | |
| R.T.*) | DIN 53 483 | 5,2 | 4,8 | desgl. | 3,8 |
| 80° C | | 8,2 | 5,5 | desgl. | 4,7 |
| nach 4 h Kochwasserlagerung | | | | | |
| R.T.*) | | 10,6 | 6,6 | desgl. | 4,7 |
| 80° C | | 22,6 | 6,6 | desgl. | 7,1 |
| Spez. Durchgangswiderstand | | | | | |
| R.T.*) | DIN 53 482 | $1,6 \cdot 10^{15}$ | $1,1 \cdot 10^{16}$ | desgl. | $6,1 \cdot 10^{15}$ |
| $\Omega \cdot$ cm 80° C | | $4,8 \cdot 10^{10}$ | $1,9 \cdot 10^{12}$ | desgl. | $5,3 \cdot 10^{11}$ |
| nach 4 h Kochwasserlagerung | | | | | |
| R.T.*) | | $1,4 \cdot 10^{11}$ | $2,6 \cdot 10^{11}$ | $\sim 2,5 \cdot 10^{12}$ | $3,8 \cdot 10^{14}$ |
| 80° C | | $3,9 \cdot 10^{13}$ | $4,2 \cdot 10^{13}$ | $\sim 4,0 \cdot 10^{14}$ | $7,7 \cdot 10^{12}$ |

*) R.T. = Raumtemperatur
**) GUT= Glasumwandlungstemperatur

## Beispiele 4 und 5

Die Arbeitsweisen der Beispiele 4 und 5 sind in Tabelle 2 veranschaulicht. Der dibromierte Bisphenol-A-glycidyläther, der Dibromkresolglycidyläther und der Bisphenol-A-glycidyläther gemäß Beispiel 1 sind die möglichen Komponenten für die jeweiligen Harzkomponenten (A). Alle übrigen Substanzen sind Bestandteile der jeweiligen Härterkomponente (B).

Aus den unten angegebenen Prüfwerten läßt sich entnehmen, daß die Exothermie bei Anwendung des erfindungsgemäßen Verfahrens sehr gering ist.

Die Spitzentemperatur wird gemessen, indem 100 g der Mischung bei Raumtemperatur in einen Kartonbecher gefüllt werden und derselbe in einen Umluftofen mit einer Betriebstemperatur von 80° C gestellt wird. Die Temperatur der Mischung wird bis zum Überschreiten der Spitze gemessen.

Tabelle II

| Komponenten | | Beispiel Nr. 4 | 5 |
|---|---|---|---|
| Dibromierter Bisphenol-A-glycidyläther | | 24,0 | – |
| Dibromkresolglycidyläther | | 25,0 | – |
| Bisphenol-A-glycidyläther gemäß Beispiel 1 | | 51,0 | 100,0 |
| Methyltetrahydrophthalsäureanhydrid | | 62,8 | 26,7 |
| Halbester aus 2 Mol Tetrahydrophthalsäureanhydrid 1 Mol Neopentylglykol | | 6,0 | 6,7 |
| Zinkfluorborat-Tetrahydropyran-Komplex gem. Beispiel 1 | | 1,2 | 1,6 |
| Polyesterpolyol (Capa 305®) | | – | 6,7 |
| Pot-life**), ab Raumtemperatur | min | 32 | 8 |
| Gelierzeit auf B-Zeit-Metallplatte bei 80° C | min | 2 | 1 |
| Spitzentemperatur**) bei Starttemp. von 80° C | °C<br>nach min | 160<br>15 | 180<br>12 |

*) Gewichtsteile
**) bei 100-g-Mischung

**Patentansprüche**

1. Verfahren zur Herstellung von Epoxidharzgießkörpern durch Umsetzung einer flüssigen, polyfunktionellen Epoxidverbindung, eines Carbonsäureanhydrids, gegebenenfalls einer Carbonsäure und/oder eines Carbonsäureesters, einer Bortrifluorid-Komplexverbindung, Wasser, eines cyclischen Äthers und einer oder mehrerer Verbindungen (X), welche mindestens 2 OH-Gruppen oder mindestens 2 COOH-Gruppen oder gleichzeitig mindestens 1 OH-Gruppe und mindestens 1 COOH-Gruppe aufweisen, aus der Gruppe aliphatischer Glykole, Polyester und Polyäther mit endständigen OH-Gruppen, Polyester mit endständigen COOH-Gruppen und Halbester von Dicarbonsäureanhydriden, welche die Anhydridgruppe an einem carbocyclischen Ring tragen, mit Polyolen, dadurch gekennzeichnet, daß man als Bortrifluorid-Komplexverbindung eine Zinkfluorborat-Komplexverbindung und als cyclischen Äther Tetrahydropyran einsetzt, wobei die Mischungsbestandteile bei der Umsetzung in einem solchen Mengenverhältnis vorliegen, daß auf 100 Gewichtsteile der Epoxidverbindung mehr als 10 Gewichtsteile, vorzugsweise 50 Gewichtsteile, der Summe aus Carbonsäureanhydrid, gegebenenfalls Carbonsäure und/oder Carbonsäureester, Zinkfluorborat-Komplexverbindung, Wasser, Tetrahydropyran und Verbindung (X) kommen und auf 1 Epoxidäquivalent 0,01 bis 1,0 Mol Wasser, 0,02 bis 0,2 Mol Tetrahydropyran, 0,5 bis 1,8 Säureäquivalente und 0,5 bis 2,5 g $BF_3$ der Zinkfluorborat-Komplexverbindung kommen, mit der Maßgabe, daß bei der Berechnung der Carbonsäureäquivalente Carbonsäureanhydrid und Carbonsäureester als Carbonsäure gerechnet werden.

2. Verfahren nach Anspruch 1, dadurch gekennzeichnet, daß man als Zinkfluorborat-Komplexverbindung eine solche der Formel

$$Zn(BF_4)_2 \cdot 4\ H_2O$$

einsetzt, wobei das komplex gebundene Wasser zu dem gesamten Wasser des Reaktionsgemisches zu zählen ist.

3. Verfahren nach Anspruch 1, dadurch gekennzeichnet, daß man als Zinkfluorborat-Komplexverbindung eine solche einsetzt, welche Tetrahydropyran und gegebenenfalls Wasser enthält, wobei das komplex gebundene Wasser zu dem gesamten Wasser des Reaktionsgemisches und das komplex gebundene Tetrahydropyran zu dem gesamten Tetrahydropyran des Reaktionsgemisches zu zählen sind.

4. Verfahren nach Anspruch 1, dadurch gekennzeichnet, daß man ein bei Raumtemperatur flüssiges Carbonsäureanhydrid oder ein bei Raumtemperatur flüssiges Carbonsäureanhydridgemisch einsetzt.

5. Verfahren nach Anspruch 1, dadurch gekennzeichnet, daß man ein bei Raumtemperatur flüssiges Gemisch eines oder mehrerer Carbonsäureanhydride mit einer oder mehreren Carbonsäuren und/oder einem oder mehreren Carbonsäureestern einsetzt.

6. Verfahren nach Anspruch 1, dadurch gekennzeichnet, daß man als Verbindung (X) ein Alkylenglykol mit mindestens 2 OH-Gruppen und mit 2 bis 10 Kohlenstoffatomen oder einem Polyalkylenglykoläther mit einem Molekulargewicht von maximal 1000 einsetzt, wobei in der Reaktionsmischung auf 1 Epoxidäquivalent 0,01 bis 0,08 OH-Äquivalente dieser Verbindung (X) kommen.

7. Verfahren nach Anspruch 1, dadurch gekennzeichnet, daß man als Verbindung (X) einen Polyester mit mindestens 2 OH-Gruppen einsetzt, welcher entweder durch Reaktion einer organischen Dicarbonsäure oder eines veresterungsfähigen Derivates dieser Dicarbonsäure mit einem Diol oder einem veresterungsfähigen Derivat dieses Diols im Überschuß, oder durch Reaktion der COOH-Gruppe eines Polylactons mit einem Polyol (oder Polyolderivat) gewonnen wurde, wobei in der Reaktionsmischung auf 1 Epoxydäquivalent 0,01 bis 0,08, OH-Äquivalente dieser Verbindung (X) kommen.

8. Verfahren nach Anspruch 1, dadurch gekennzeichnet, daß man als Verbindung (X) einen Polyester mit mindestens 2 COOH-Gruppen einsetzt, welcher entweder durch Reaktion einer organischen Dicarbonsäure oder eines veresterungsfähigen Derivates dieser Dicarbonsäure im Überschuß mit einem Diol oder einem veresterungsfähigen Derivat dieses Diols, oder durch Reaktion der OH-Gruppe eines Polylactons mit einer organischen Dicarbonsäure (oder Derivat davon) gewonnen wird, wobei in der Reaktionsmischung auf 1 Epoxidäquivalent 0,01 bis 0,08 COOH-Äquivalente dieser Verbindung (X) kommen.

9. Verfahren nach Anspruch 1, dadurch gekennzeichnet, daß man als Verbindung (X) einen Polyäther mit mindestens 2 OH-Gruppen einsetzt, welcher durch Vorverlängerungsreaktion eines niedermolekularen Polyols mit Äthylen- oder Propylenoxid hergestellt wird, wobei in der Reaktionsmischung auf 1 Epoxidäquivalent 0,01 bis 0,08, OH-Äquivalente dieser Verbindung (X) kommen.

10. Verfahren nach Anspruch 1, dadurch gekennzeichnet, daß man als Verbindung (X) einen Halbester aus Phthalsäureanhydrid, Tetrahydrophthalsäureanhydrid oder Hexahydrophthalsäureanhydrid mit einem aliphatischen Polyol, welcher infolge von Weiterveresterung auch als Oligomeres mit einem Molekulargewicht bis zu 500 vorliegen kann, einsetzt.

11. Verfahren nach Anspruch 1, dadurch gekennzeichnet, daß man die Umsetzung bei Temperaturen zwischen 75 und 120°C durchführt und gegebenenfalls den erhaltenen Gießkörper nachträglich noch bei Temperaturen bis zu 100°C tempert.

12. Verfahren nach Anspruch 1, dadurch gekennzeichnet, daß man das Verfahren stufenweise durchführt.

13. Verfahren nach Anspruch 1, dadurch gekennzeichnet, daß man Gießkörper herstellt, welche elektrische Teile, insbesondere wärmeempfindliche Elektronikteile, umhüllen bzw. einkapseln.

**Claims**

1. A process for the production of epoxy resin castings by reaction of a liquid polyfunctional epoxy compound, a carboxylic anhydride, optionally a carboxylic acid and/or a carboxylic acid ester, a boron trifluoride complex compound, water, a cyclic ether, and one or more compounds (X) which contain at least two OH groups or at least two COOH groups, or together contain at least one OH group and one COOH group, said compounds (X) being selected from the group consisting of aliphatic glycols, polyesters and polyethers with terminal OH groups, polyesters with terminal COOH groups, and hemiesters of dicarboxylic anhydrides which carry the anhydride group at a carbocyclic ring, with polyols, which process comprises the use of a zinc fluoroborate complex compound as boron trifluoride complex compound and tetrahydropyrane as cyclic ether, the ratio of the ingredients employed in the reaction being such that the mixture contains, per 100 parts by weight of epoxy compound, more than 10 parts by weight, preferably 50 parts by weight, of the sum of carboxylic anhydride, optionally carboxylic, acid and/or carboxylic acid ester, zinc fluoroborate complex compound, water, tetrahydropyrane and compound (X), and, per 1 epoxide equivalent, 0.01 to 1.0 mole of water, 0.02 to 0.2 mole of tetrahydropyrane, 0.5 to 1.8 acid equivalents, and 0.5 to 2.5 g of $BF_3$ of the zinc fluoroborate complex compound, with the proviso that, when calculating the carboxylic acid equivalents, carboxylic anhydride and carboxylic acid ester are counted as carboxylic acid.

2. A process according to claim 1, which comprises the use of a zinc fluoroborate complex compound of the formula

$$Zn(BF_4)_2 \cdot 4\,H_2O,$$

in which compound the complexed water is part of the total amount of water of the reaction mixture.

3. A process according to claim 1, which comprises the use of a zinc fluoroborate complex compound which contains tetrahydropyrane and, optionally, water, in which compound the complexed water is part of the total amount of water of the reaction mixture, and the complexed tetrahydropyrane is part of the total amount of tetrahydropyrane of the reaction mixture.

4. A process according to claim 1, which comprises the use of a carboxylic anhydride which is liquid at room temperature, or a mixture of carboxylic anhydrides, which mixture is liquid at room temperature.

5. A process according to claim 1, which comprises the use of a mixture of one or more carboxylic anhydrides with one or more carboxylic acids and/or one or more carboxylic acid esters, which mixture is liquid at room temperature.

6 A process according to claim 1, wherein the compound (X) is an alkylene glycol containing at least two OH groups and 2 to 10 carbon atoms, or a polyalkylene glycol ether having a maximum molecular weight of 1000, the reaction mixture containing, per 1 epoxide equivalent, 0.01 to 0.08 OH equivalent of said compound (X).

7. A process according to claim 1, wherein the compound (X) is a polyester which contains at least two OH groups and which has been obtained either by reaction of an organic dicarboxylic acid, or of an esterifiable derivative thereof, with an excess of a diol or an esterifiable derivative thereof, or by reaction of the COOH group of a polylactone with a polyol (or polyol derivative), the reaction mixture containing, per 1 epoxide equivalent, 0.01 to 0.08 OH equivalent of said compound (X).

8. A process according to claim 1, wherein the compound (X) is a polyester which contains at least two COOH groups, and which is obtained by reaction of an excess of an organic dicarboxylic acid, or of an esterifiable derivative thereof, with a diol or an esterifiable derivative thereof, or by reaction of the OH group of a polylactone with an organic dicarboxylic acid (or a derivative thereof), the reaction mixture containing, per 1 epoxide equivalent, 0.01 to 0.08 COOH equivalent of said compound (X).

9. A process according to claim 1, wherein the compound (X) is a polyether which contains at least two OH groups, and which is obtained by advancement reaction of a low molecular polyol with ethylene oxide or propylene oxide, the reaction mixture containing, per 1 epoxide equivalent, 0.01 to 0.08 OH equivalent of said compound (X).

10. A process according to claim 1, wherein the compound (X) is a hemiester of phthalic anhydride, tetrahydrophthalic anhydride or hexahydrophthalic anhydride with an aliphatic polyol which, as a result of further esterification, can also exist in the form of an oligomer with a molecular weight of up to 500.

11. A process according to claim 1, wherein the reaction is carried out in the temperature range from 75° to 120° C, and the castings obtained are obtionally post-cured at a temperature up to 100° C.

12. A process according to claim 1, wherein the process is carried out stepwise.

13. A process according to claim 1 for the production of castings for encapsulating or encasing electrical components, in particular heat-sensitive electronic components.

**Revendications**

1. Procédé de fabrication d'objets coulés en résines époxydiques par réaction d'un composé époxydique polyfonctionnel liquide, d'un anhydride d'acide carboxylique, éventuellement d'un acide carboxylique et/ou d'un ester d'acide carboxylique, d'un complexe du trifluorure de bore, d'eau, d'un éther cyclique et d'un ou plusieurs composés (X) qui contiennent au moins deux radicaux -OH, ou au moins deux radicaux -COOH, ou en même temps au moins un radical -OH et au moins un radical -COOH et qui appartiennent à l'ensemble constitué par les glycols aliphatiques, les polyesters et les polyéthers à radicaux -OH terminaux, les polyesters à radicaux -COOH terminaux et les hémi-esters dérivant, d'une part, d'anhydrides d'acides dicarboxyliques dont le radical anhydride est porté par un noyau carbocyclique et, d'autre part, de polyols, procédé caractérisé en ce qu'on met en jeu, comme complexe du trifluorure de bore, un complexe du fluoroborate de zinc et, comme éther cyclique, le tétrahydropyranne, les constituants étant présents dans le mélange, au cours de la réaction, en un rapport de quantités tel que pour 100 parties en poids du composé époxydique il y ait plus de 10 parties en poids, de préférence 50 parties en poids, de l'ensemble constitué par l'anhydride d'acide carboxylique, éventuellement l'acide carboxylique et/ou l'ester d'acide carboxylique, le complexe de fluoroborate de zinc, l'eau, le tetrahydropyranne et le composé (X), et, pour un équivalent d'époxyde, de 0,01 à 1,0 mole d'eau, de 0,02 à 0,2 mole de tétrahydropyranne, de 0,5 à 1,8 équivalent d'acide et de 0,5 à 2,5 g de $BF_3$ provenant du complexe de fluoroborate de zinc, avec la condition que l'anhydride d'acide carboxylique et l'ester d'acide carboxylique soient comptés comme acides carboxyliques pour le calcul du nombre d'équivalents d'acide carboxylique.

2. Procédé selon la revendication 1 caractérisé en ce qu'on utilise, comme complexe de fluoroborate de zinc, un complexe de formule

$$Zn(BF_4)_2 \cdot 4\ H_2O,$$

l'eau liée au complexe devant être comptée dans l'eau totale du mélange réactionnel.

3. Procédé selon la revendication 1 caractérisé en ce qu'on utilise, comme complexe de fluoroborate de zinc, un complexe de ce genre qui contient du tétrahydropyranne et éventuellement de l'eau, l'eau liée au complexe devant être comptée dans l'eau totale du mélange réactionnel, et le tétrahydropyranne lié au complexe devant également être compté dans le tétrahydropyranne total du mélange réactionnel.

4. Procédé selon la revendication 1 caractérisé en ce qu'on utilise un anhydride d'acide carboxylique liquide à la température ambiante, ou un mélange d'anhydrides d'acides carboxyliques liquide à la température ambiante.

5. Procédé selon la revendication 1 caractérisé en ce qu'on utilise un mélange, liquide à la température

ambiante, d'un ou de plusieurs anhydrides d'acides carboxyliques avec un ou plusieurs acides carboxyliques et/ou un ou plusieurs esters d'acides carboxyliques.

6. Procédé selon la revendication 1 caractérisé en ce qu'on utilise, comme composé (X), un alkylène-glycol qui contient au moins deux radicaux -OH et qui contient de 2 à 10 atomes de carbone, ou un éther de polyalkylène-glycol dont le poids moléculaire est d'au plus 1000, le mélange réactionnel renfermant, pour 1 équivalent d'époxyde, de 0,01 à 0,08 équivalent d'-OH de ce composé (X).

7. Procédé selon la revendication 1 caractérisé en ce qu'on utilise, comme composé (X), un polyester qui contient au moins deux radicaux -OH et qui a été obtenu soit par réaction d'un acide dicarboxylique organique, ou d'un dérivé estérifiable d'un tel acide dicarboxylique, avec un excès d'un diol ou d'un dérivé réactif d'un tel diol, soit par réaction du radical -COOH d'une polyactone avec un polyol (ou un dérivé de polyol), le mélange réactionnel contenant, pour 1 équivalent d'époxyde, de 0,01 à 0,08 équivalent d'-OH de ce composé (X).

8. Procédé selon la revendication 1 caractérisé en ce qu'on utilise, comme composé (X), un polyester qui contient au moins deux radicaux -COOH et qui a été préparé soit par réaction d'un excès d'un acide dicarboxylique organique, ou d'un dérivé estérifiable d'un tel acide dicarboxylique, avec un diol ou un dérivé estérifiable d'un tel diol, soit par réaction du radical -OH d'une polylactone avec un acide dicarboxylique organique (ou un dérivé de celui-ci), le mélange réactionnel contenant, pour 1 équivalent d'époxyde, de 0,01 à 0,08 équivalent de -COOH de ce composé (X).

9. Procédé selon la revendication 1 caractérisé en ce qu'on utilise, comme composé (X), un polyéther qui contient au moins deux radicaux -OH et qui a été préparé par une réaction de pré-allongement d'un polyol à bas poids moléculaire avec l'oxyde d'éthylène ou l'oxyde de propylène, le mélange réactionnel contenant, pour 1 équivalent d'époxyde, de 0,01 à 0,08 équivalent d'-OH de ce composé (X).

10. Procédé selon la revendication 1 caractérisé en ce qu'on utilise, comme composé (X), un hémi-ester dérivant, d'une part, de l'anhydride phtalique, de l'anhydride tétrahydrophtalique ou de l'anhydride hexahydrophtalique et, d'autre part, d'un polyol aliphatique, cet hémi-ester pouvant également se trouver, du fait d'une estérification complémentaire, sous la forme d'un oligomère dont le poids moléculaire peut aller jusqu'à 500.

11. Procédé selon la revendication 1 caractérisé en ce qu'on effectue la réaction à des températures comprises entre 75 et 120°C et en ce qu'on soumet éventuellement l'objet moulé obtenu à un recuit effectué à des températures pouvant aller jusqu'à 100°C.

12. Procédé selon la revendication 1 caractérisé en ce que le procédé est exécuté par étapes.

13. Procédé selon la revendication 1 caractérisé en ce qu'on fabrique des objets coulés qui enrobent ou encapsulent des pièces électriques, plus particulièrement des composants électroniques sensibles à la chaleur.